Europäisches Patentamt

European Patent Office

Office européen des brevets

(19)

(11) Publication number: **0 413 590 A2**

# EUROPEAN PATENT APPLICATION

(21) Application number: 90309032.2

(22) Date of filing: 17.08.90

(51) Int. Cl.5: **G11C 7/00, G11C 8/00**

(30) Priority: 18.08.89 JP 213504/89

(43) Date of publication of application:
20.02.91 Bulletin 91/08

(84) Designated Contracting States:
DE FR GB

(71) Applicant: FUJITSU LIMITED
1015, Kamikodanaka Nakahara-ku
Kawasaki-shi Kanagawa 211(JP)

(72) Inventor: Suzuki, Takaaki
4-3-22 Nishiikuta, Tama-ku
Kawasaki-shi, Kanagawa 214(JP)

Inventor: Tokoro, Masahiro
532 Shimokodanaka, Nakahara-ku
Kawasaki-shi, Kanagawa 211(JP)
Inventor: Nomura, Yukihiro
71-3 Akutsu, Takatsu-ku
Kawasaki-shi, Kanagawa 213(JP)
Inventor: Tatematsu, Takeo
6-1-35 Aihara
Sagamihara-shi, Kanagawa 229(JP)

(74) Representative: Rackham, Stephen Neil et al
GILL JENNINGS & EVERY 53-64 Chancery
Lane
London WC2A 1HN(GB)

(54) Wafer scale integrated circuit device.

(57) In a wafer scale integrated circuit device having functional blocks $(2_{11}, 2_{12}, \ldots 2_{nm})$ in rows and columns on the wafer (1) each of blocks are interconnected by local lines, power supply lines, and input signal lines constituted by a command signal transmitting line (43) and a wafer clock signal transmitting line (42). Input protection $(5_{11}, 5_{12}, \ldots 5_{nm}; 6_{11}, 6_{12} \ldots 6_{nm})$ for preventing an overshot or undershot level of the input signal are provided between each functional block and the command signal transmitting line (43) and the wafer clock signal transmitting line (42). Consequently, the input command signal (CMND) and the wafer clock signal (WCK) are delayed and rounded to the same degree for each and every functional block. Therefore, a high operational speed with a small operational margin can be realized by preventing synchronization error.

*FIg. 6*

EP 0 413 590 A2

## WAFER SCALE INTEGRATED CIRCUIT DEVICE

The present invention relates to a wafer scale integrated (WSI) circuit device comprising an array of integrated circuit modules on the wafer. The modules correspond more or less to the "chips" which would result were the wafer to be diced. More particularly, the present invention relates to a wafer scale integrated circuit device made to function as one device, such as a wafer scale memory constituted by combining all chips formed on one piece of semiconductor wafer using a bonding wire for supplying power supply voltage or common signals to the plurality of chips.

The wafer scale integrated circuit device is used for a processor, a logic circuit, a memory and the like. In such wafer scale integrated circuit device, for example, power supply lines and common signal lines are formed by bonding wires, since those lines should have low impedance characteristics and bonding wire has low impedance characteristics.

Recently, a wafer scale integrated circuit device, which is used for a processor, a logic circuit, a memory and the like, has been developed and prototype devices have been provided. In the wafer scale integrated circuit device, a plurality of circuits are integrated in all regions of the wafer. For example in a wafer scale processor device, a wafer includes an array of chips having a logic circuit, a read only memory circuit, or a random access memory circuit made of an EPROM (Erasable Programmable Read Only Memory), and in a wafer scale memory device, a wafer includes an array of chips each having a memory circuit.

In the art of wafer scale integrated circuits, the following merits are provided:

(A) A larger scale circuit can be integrated on the wafer than any other large scale integrated circuit (LSI);

(B) Signal delay time can be shortened, since a mutual wiring distance between circuits becomes shorter by integrating a system on one piece of wafer;

(C) Reliability of the system can be improved by compensating for defective chips of the wafer or defective portions in the chip, and reliability of mounting can be improved by decreasing assembling processes.

Generally in the wafer scale integrated circuit device, local lines are used for chip to chip connections between neighboring chips whereas global lines extend to all chips and comprise both power supply lines and one or more common lines for carrying input signals. Usually, there are two common signal lines for transmitting an input signal, a wafer clock (WCK) signal transmitting line and a command strobe (CMND) signal transmitting line, each of which is shared by a plurality of IC chips. Incidentally, there is a possibility that the input signal may contain an overshot level or an undershot level which may cause the IC chips to breakdown. Accordingly, in such a wafer scale integrated circuit device, an input protection circuit for protecting against a breakdown of the IC chips from an overshot level or undershot level is nessesary.

However, in the conventional wafer scale integrated circuit device including the input protection circuit, the input protection circuit is added between an input terminal for a WCK signal and the WCK signal transmitting line, and between an input terminal for a CMND signal and the CMND signal transmitting line, so that the load of the WCK signal transmitting line and the CMND signal transmitting line formed by bonding wires is large, and the transmission of the input signals are delayed and the wave shape is rounded. Accordingly, when an operational margin of the input signals is designed to be small, a synchronization error occurs between the IC chip located near the input terminal and the IC chip located far from the input terminal due to the time delay of the signal transmission in the WCK signal transmitting line and the CMND signal transmitting line. From these reasons, it is necessary to make the operational margin large and this prevents an increase in operational speed of the conventional wafer scale integrated circuit device.

According to this invention a wafer scale integrated circuit device comprising:

a wafer;

a plurality of functional blocks arranged in rows and columns on the wafer;

at least one terminal for receiving an external input signal;

at least one signal transmitting line for supplying the external input signal to each functional block from the terminal; and,

input circuit protection means, is characterised in that the input circuit protection means comprises:

a plurality of input protection circuits provided individually between each of the functional blocks and the signal transmitting line.

The present invention provides a wafer scale integrated circuit device which surely realizes a high operational speed with a small operational margin by preventing a synchronization error since the individual input protection circuits delay and round the input signals to each block to the same degree.

The present invention will be more clearly understood from the description of the preferred embodiments as set forth below with reference to the accompanying drawings, wherein:

Fig. 1 is a plan view showing cutting of the wafer in the prior art;

Figure 2 is an enlarged plan view of a main portion of the wafer shown by a dot and dash line in Fig. 1;

Fig. 3 is an enlarged plan view of a main portion of the wafer shown by a dash line as shown in Fig. 1;

Fig. 4A is a circuit diagram of the conventional wafer scale integrated circuit device having an input protection circuit;

Fig. 4B is a detailed circuit diagram of one example of the functional block as shown in Fig. 4A;

Figs. 5A to 5F are waveforms showing the time delay of the CMND signal and the WCK signal in the common lines;

Fig. 6 is a circuit diagram of the wafer scale integrated circuit device of the present invention having an input protection circuit;

Fig. 7 is an one embodiment of a wafer scale integrated circuit device having an input protection circuit according to the present invention;

Figs. 8A to 8F are waveforms showing the CMND signal and the WCK signal in the common lines according to the present invention;

Figs. 9 to 11 are other embodiments of the input protection circuit according to the present invention.

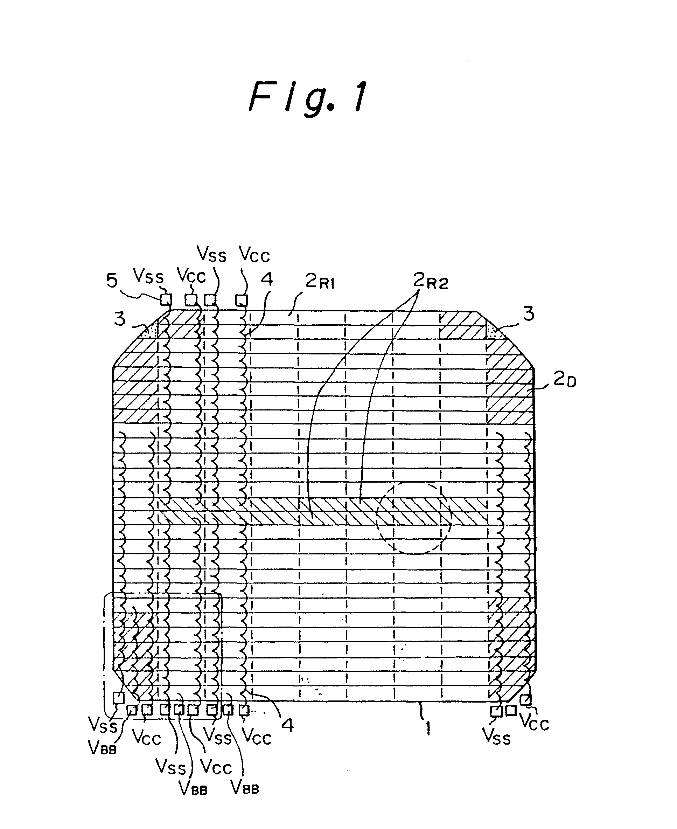

Before describing the preferred embodiments of the present invention, an explanation will be given of the conventional wafer scale integrated circuit device shown in Figs. 1 to 5.

Figure 1 is a plan view showing cutting of a prior art wafer 1 constituting a wafer scale memory from a disk shape into a square shape suitable for mounting on the carrier. In Fig. 1, reference 1 denotes a wafer, references $2_{R1}$ and $2_{R2}$ denote real chips (actual working chips) arranged in rows and columns, $2_D$ denotes a terminal chip arranged in the corner of the wafer 1, 3 denotes a metal film, 4 denotes a bonding wire for use as power supply lines $V_{BB}$, $V_{CC}$, or $V_{SS}$, or signal lines (not shown in Fig. 1), and 5 denotes a square shape input pad made of metal which will be connected to the input terminal.

In a wafer scale memory, a plurality of terminal chips $2_D$ are provided in the circumference of the wafer 1. Therefore, when power supply lines such as $V_{CC}$ lines and $V_{SS}$ lines are constituted by bonding wires 4, the terminal chips $2_D$ can be used for relay points, and thus long wiring portions can be decreased.

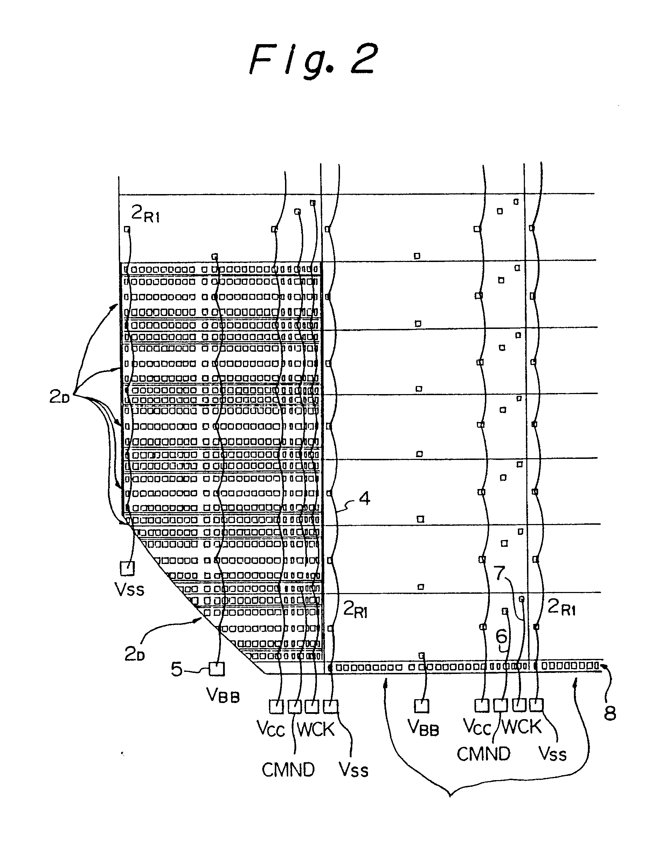

Figure 2 is an enlarged plan view of a lower left corner portion of the wafer 1 shown by a dot and dash line in Fig. 1, and the same references in Fig. 2 as in Fig. 1 indicate the same portions or same meanings as in Fig. 1. In Fig. 2, reference 6 denotes a command strobe (CMND) signal transmitting line, 7 denotes a wafer clock (WCK) signal transmitting line, 8 denotes a metal pad of a relay point in the terminal chip $2_D$, and $V_{BB}$ denotes a substrate voltage supply line. The terminal chip $2_D$ has a plurality of metal pads made of aluminium and the like for relaying a bonding wire, each of the metal pads is at an electrically floating state. When forming the terminal chip $2_D$ shown in Fig. 2 onto the wafer, for example, metal pads 8 made of aluminium and a cover film (which is not indicated in the drawing) are printed on the terminal chip $2_D$, and the other processes are not carried out.

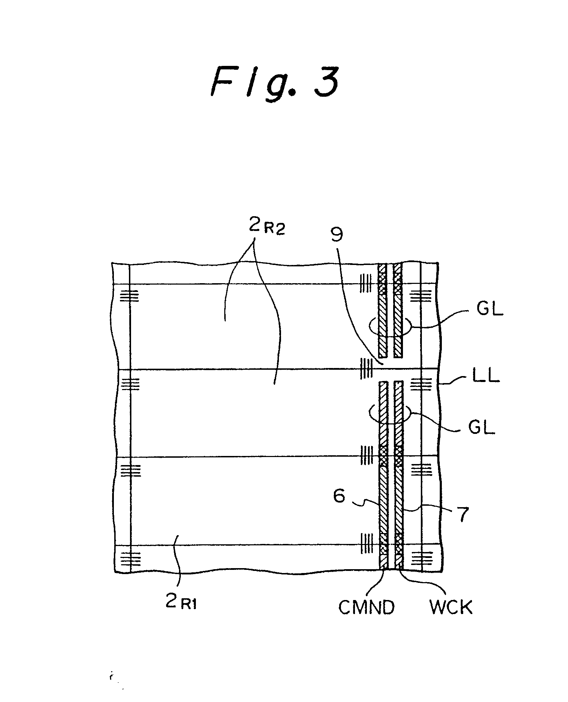

Figure 3 is an enlarged plan view of a circular portion indicated by a broken line in Fig. 1, and the same references in Fig. 3 as in Figs. 1 and 2 indicate the same portions or the same meanings as in Figs. 1 and 2. In Fig. 3, reference LL denotes a local line, and GL denotes a global line which includes the CMND signal transmitting line 6 and the WCK signal transmitting line 7, and the chips are interconnected by the local line LL and global line GL. The local lines LL are connected between neighboring chips whereas the global lines GL are extended to connect an array of chips in a column direction on the wafer 1. The CMND signal transmitting line 6 and the WCK signal transmitting line 7 are explained above as two common signal lines for transmitting an input signal. The end portion of the global line GL and power supply lines are connected to the input pad 5 outside the wafer 1 shown in Fig. 1, and the input pads 5 are connected to the input terminal (not shown).

In the real chips $2_{R2}$ which are arranged in a row direction in the center of the wafer 1 and indicated by hatching lines from the upper left side to the lower right side in Fig. 1, the global lines GL are divided into an upper part and lower part by a dividing portion 9. The reason for the separation of the global lines GL into two parts is to decrease the damage when a defect occurs on a certain global line GL, since wafer faults are unavoidable at the wafer scale level.

Generally in the wafer scale integrated circuit device, input signal lines for transmitting input signals such as the CMND signal transmitting line 6 or the WCK signal transmitting line 7 are connected to a plurality of IC chips. On the other hand, the input signal has the possibility of containing a noise signal having an extra high level (overshot level) or an extra low level (undershot level) which can breakdown the IC chip. Accordingly, an input protection circuit for guarding the IC chips from an overshot level or undershot level is required in the wafer scale integrated circuit device.

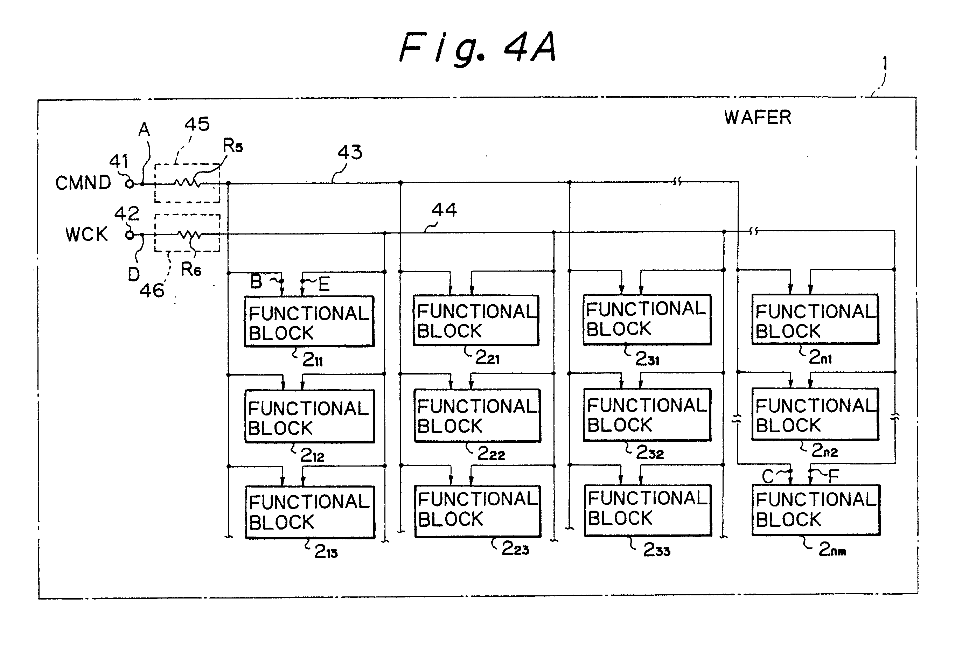

Figure 4A shows an equivalent circuit diagram of a conventional wafer scale integrated circuit device having an input protection circuit as shown in Figs. 1 to 3. In Fig. 4A, reference 1 denotes a wafer,

$$2_{11}$$

to $2_{nm}$ (n and m are natural number) denote functional blocks eqivalent to the real chips $2_{R2}$ arranged in rows and columns as shown in Fig. 1, 41 and 42 denote input terminals for the CMND signal and the WCK signal, 43 and 44 denote the CMND signal transmitting line and the WCK signal transmitting line, 45 and 40 denote input protection circuits consisting of resistors $R_1$ and $R_2$.

If the overshot level or the undershot level noise is contained in the input CMND signal or WCK signal in the conventional wafer scale integrated circuit device shown in Fig. 4A, the functional blocks $2_{11}$ to $2_{nm}$ are all protected from breakdown because the overshot level or the undershot level is relaxed by the resistor $R_5$ or $R_6$.

Contrary to this, in the conventional wafer scale integrated circuit device shown in Fig. 4A, the input protection circuit 44 and 45 are connected in series to the first end of the input signal lines 43 and 44, so that the load of the CMND signal transmitting line 43 and the WCK signal transmitting line 44 formed by bonding wires is large and the transmission of the input signals are delayed and rounding of the wave shape occurrs. Further, the degree of time delay in the CMND signal transmitting line 43 and the WCK signal transmitting line 44 depends on the time constant value due to the resistance value of the input protection circuit 45 and 46 and the capacitance value of each line 43 and 44.

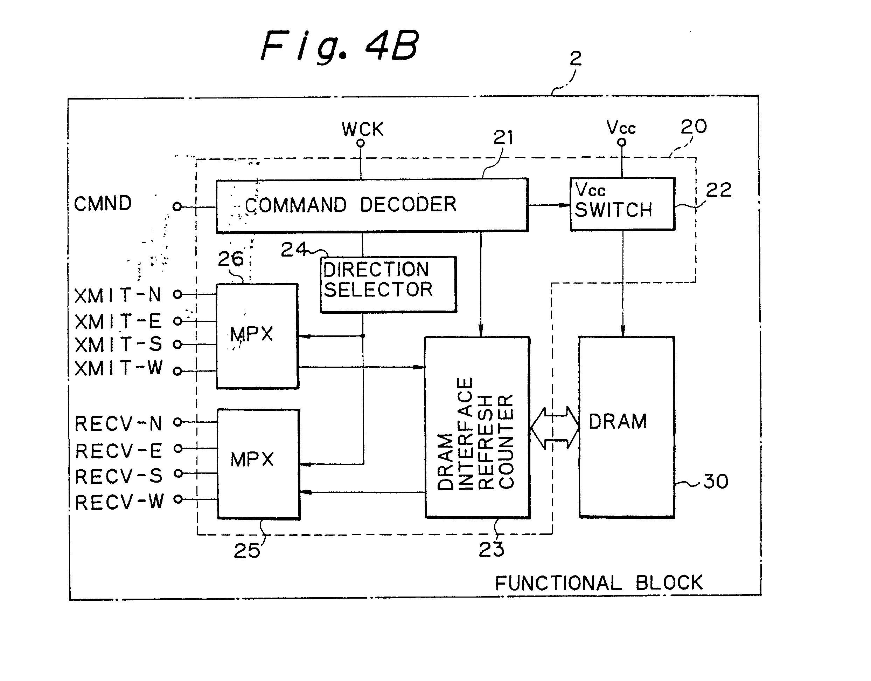

Figure 4B is a detailed circuit block diagram of one example of the functional block as shown in Fig. 4A. In Fig. 4B, a part 2 enclosed by dot and dash line denotes a functional block, a part 20 enclosed by dotted line denotes the configuration logic. The configuration logic 20 ccmprises a command decorder 21, a Vcc switch 22, a DRAM (Dynamic Random Access Memory) interface refresh counter 23, a direction selector 24 and a multiplexers 25 and 26. A DRAM 30 is provided outside the configuration logic.

The command detector 21 receives and decodes the CMND signal input from an external circuit synchronously with the WCK signal, so as to issue instructions to other circuits in the functional block. The Vcc switch 22 controls supply of power source voltage Vcc to the DRAM 30. The DRAM interface refresh counter 23 generates signals required for the operation of the DRAM 30, such as load address strobe signals, column address strobe signals write-enable signals, output-enable signals and address signals, given from the signal supplied from the command decorder 21. These signals are used for read/write and refresh operations of the DRAM 30. The direction selector 24 issues an instruction to the receiving multiplexer 25 and the sending multiplexer 26 respectively to instruct which one of adjacent functional blocks the signal should be received from, as well as which one of the adjacent functional blocks the signal should be sent to.

The receiving multiplexer 25 selectively connects only one of the input terminals of signals RECV-N, RECV-E, RECV-S, and RECV-W respectively from the four adjacent functional blocks. The last characters of these signal names respectively denotes the connection which North, East, South or West adjacent blocks, and their terminals are respectively provided on the North, East, South and West side in each functional block. The sending multiplexer 26 selectively connects only one of output terminals of signals XMIT-N, XMIT-E, XMIT-S and XMIT-W respectively to the four adjacent functional blocks. The selective connection of these input and output terminals are all carried out by a program based on the positional information of defective functional blocks, as already described. Thus, the memory information is transmitted only via the defect-free functional blocks and the DRAM information of each functional block is serially input/output from/to the outside of wafer 1 (not shown). In this way, an as many as 200 Mbit DRAM can be fabricated on a single wafer without practically harming its production yield.

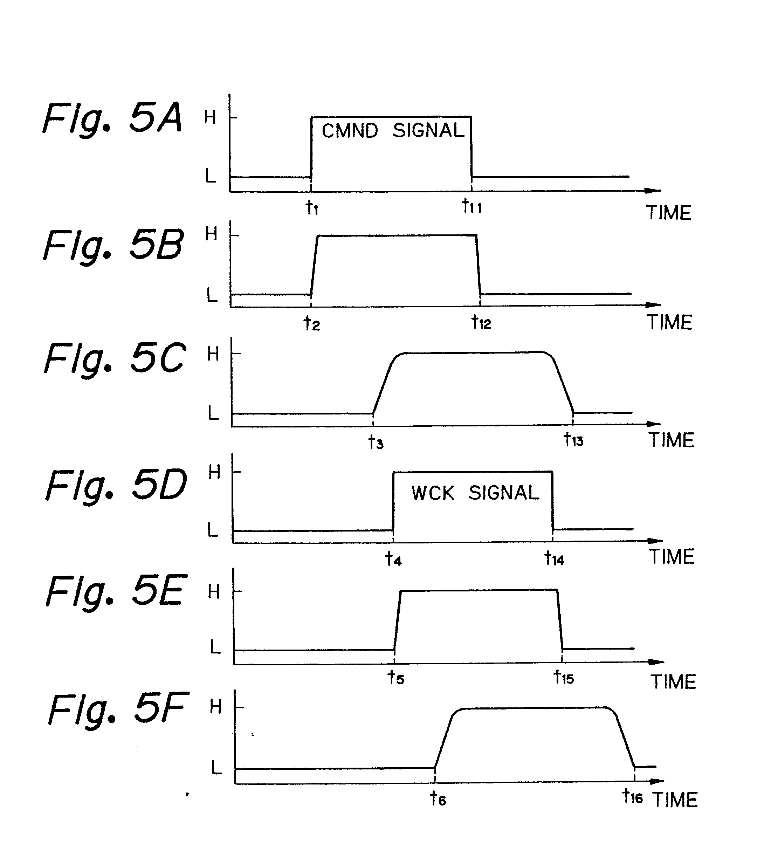

Figure 5A is a wave form at the point A shown in Fig. 4A indicating an input CMND signal. The CMND signal goes high at time $t_1$ and goes low at time

$$t_{11}.$$

Figure 5B and 5C are wave forms at the point B and C of the CMND signal transmitting line shown in Fig. 4A indicating a delay of an input CMND signal on the line 43. At point B the CMND signal turns high at time $t_2$ which is slighly later than the time $t_1$ and turns low at time

$$t_{12}$$

which is slighly later than the time $t_{11}$ as shown in Fig. 5B. At point C the CMND signal turns high at time $t_3$ which is considerably later than the time $t_1$ and turns low at time $t_{13}$ which is considerably later than the time $t_{11}$. It is obvious from Figs. 5A to 5C, the time lag and the rounding of the wave shape of the input CMND signal become large in accordance with the distance of the CMND signal transmitting line 43 from the input terminal 41.

Figure 5D is a wave form at the point D shown in Fig. 4 indicating an input WCK signal which is used for triggering and taking in the CMND signal to the functional block at the rise of the signal. The WCK signal goes high at time $t_4$ which is set between the time $t_1$ and

$$t_{11}$$

and goes low at time $t_{14}$. Figure 5E and 5F are waveforms at the points E and F of the WCK signal transmitting line shown in Fig. 4A indicating a delay of an input WCK signal on the line 44. At point E the WCK signal goes high at time $t_5$ which is slighly later than the time $t_4$ and goes low at time

$$t_{15}$$

which is slighly later than the time $t_{14}$ as shown in Fig. 5E . At point F the WCK signal goes high at time $t_6$ which is considerably later than the time $t_4$, and goes low at time $t_{16}$ which is considerably later than the time $t_{14}$. It is obvious from Figs. 5D to 5F, that the time lag and the rounding of the wave shape of the input WCK signal become large in accordance with the distance of the line 44 from the input terminal 41, but the degree of the time lag and the rounding of the wave shape of the input WCK signal is different from that of input CMND signal even if the location of the functional block is the same, since the time constant value due to the resistance value of the input protection circuit 45 and 46 and the capacitance value of each line 43 and 44 are different.

Accordingly, it is required to extend the time period of the high level of the CMND signal to synchronize the WCK signal within the high level range of the CMND signal, thereby preventing the speed up of the operational speed of the conventional wafer scale integrated circuit device.

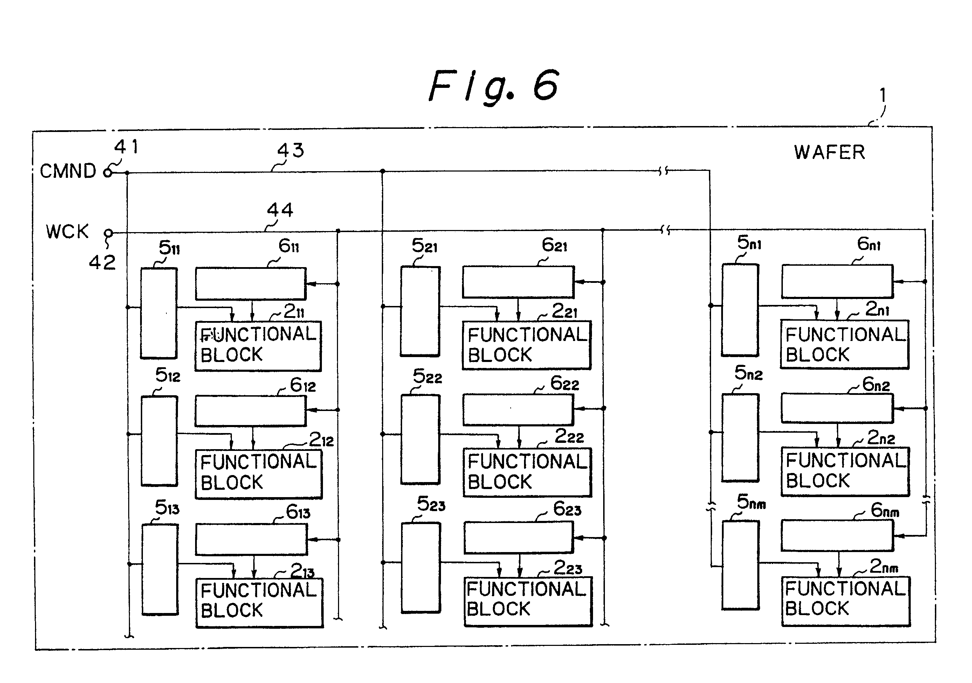

Figure 6 is a circuit diagram illustrating a wafer scale integrated circuit device according to the present invention, wherein the same references in Fig. 6 as used in Fig. 4A indicate the same portions or the same meanings as in Fig. 4A.

In Fig. 6, reference numeral 1 denotes a wafer,

$$2_{11}$$

to $2_{nm}$ denote functional blocks equivalent to the real chips $2_{R2}$ arranged in rows and columns in Fig. 1, 41 and 42 denote input terminals for the CMND signal and the WCK signal, 43 and 44 denote the CMND signal transmitting line and the WCK signal transmitting line, and $5_{11}$ to $5_{nm}$ and $6_{11}$ to $6_{nm}$ denote input protection circuits. In the present invention, the input protection circuit is not provided between the input terminal 41 and the first end of the CMND signal transmitting line nor between the input terminal 42 and the first end of the WCK signal transmitting line, but protection circuits

$$5_{11} \text{ to } 5_{nm}$$

are provided between each of functional blocks $2_{11}$ to $2_{nm}$ and the CMND signal transmitting line 43 and each of functional blocks

$$2_{11} \text{ to } 2_{nm}$$

and the WCK signal transmitting line 44.

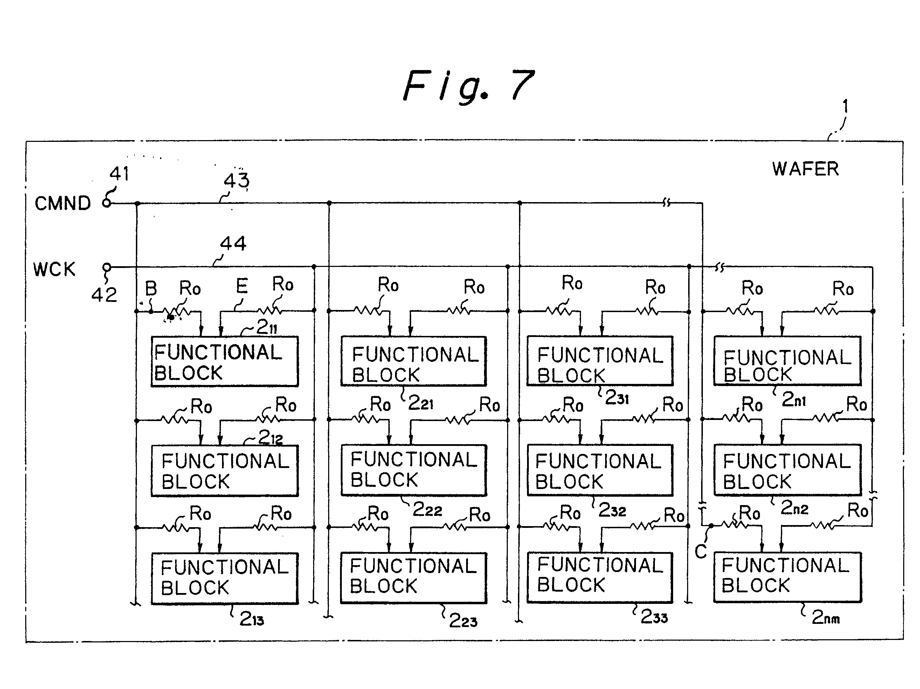

Figure 7 is a circuit diagram of one embodiment of a wafer scale integrated circuit device according to the present invention, wherein the same references in Fig. 7 as used in Fig. 6 indicate the same portions or the same meanings as in Fig. 6.

In Fig. 7, input protection circuits $5_{11}$ to $5_{nm}$ and $6_{11}$ to $6_{nm}$ are realized by a resistor $R_0$.

In this embodiment, the input CMND signal applied at the input terminal 41 is transmitted to each resistor $R_0$ through the line 43 almost simultaneously, and also the input WCK signal applied at the input terminal 42 is transmitted to each resistor $R_0$ through the line 44 almost simultaneously, and after that the CMND signal and the WCK signal are transmitted to each functional block $2_{11}$ to $2_{nm}$ being delayed and rounded by the time constant value defined by the resistance of the resistor $R_0$ and the capacitance of the line between the resistor $R_0$ and the functional block

$$2_{11} \text{ to } 2_{nm}$$

Since the the resistance of each resistor $R_0$ is almost the same and the capacitance of the line between the resistor $R_0$ and the functional block $2_{11}$ to $2_{nm}$ is small and almost the same value, the change of each CMND signal and each WCK signal is small as compared with the those signals at the input terminals 41 and 42.

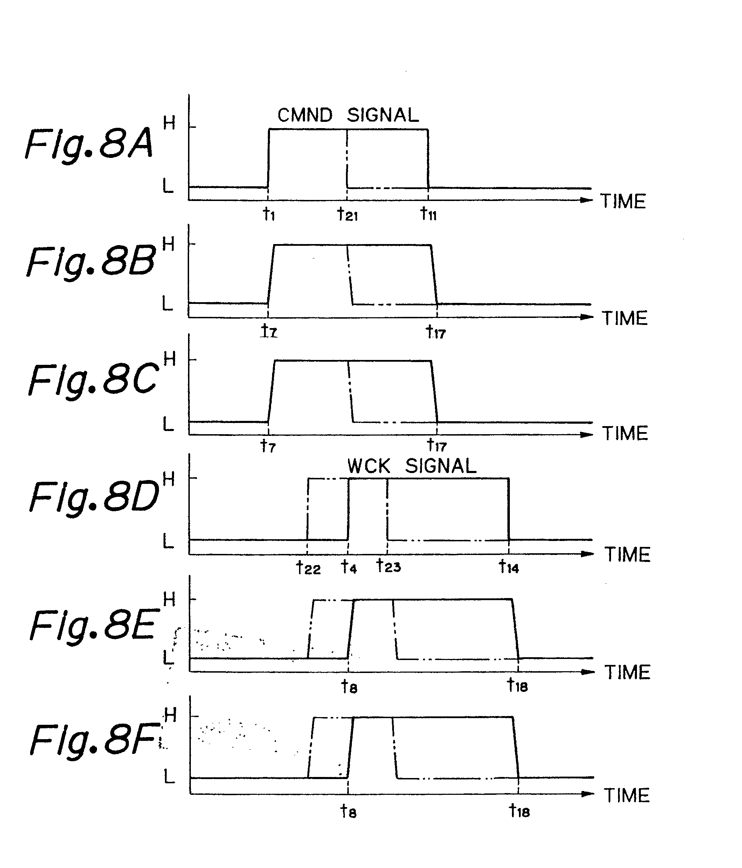

Accordingly, when the input CMND signal which turns high at time $t_1$ and turns low at time

$$t_{11}$$

is applied at the input terminal 41 as shown in Fig. 8A, waveforms at the point B and C of the line 43 become almost the same as shown in Figs. 8B and 8C. At point B and C, the CMND signal turns high at time $t_7$ which is slightly later than the time $t_1$ and turns low at time

$$t_{17}$$

which is slightly later than the time

$$t_{11}$$

due to the resistance of the resistor $R_0$ and the capacitance of the line between the resistor $R_0$ and the functional biock

$$2_{11} \text{ to } 2_{nm}.$$

It is obvious from Figs. 8A to 8C that the time iag and lhe rounding of the wave shape of the transmitted input CMND signal to any functional block are almost the same according to this embodiment.

Similarly, when the input WCK signal which goes high at time $t_4$ and goes low at time $t_{14}$ is applied at the input terminal 42 as shown in Fig. 8D, waveforms at the point E and F of the line 44 become the same as shown in Figs. 8E and 8F. At point E and F, the WCK signal goes high at time $t_8$ which is slightly later than the time $t_1$ and goes low at time $t_{18}$ which is slightly later than the time $t_{11}$ due to the resistance of the resistor $R_0$ and the capacitance of the line between the resistor $R_0$ and the functional block $2_{11}$ to $2_{nm}$. It is obvious from Figs. 8D to 8F that the time lag and the rounding of the wave shape of the transmitted input WCK signal to any functional blocks are almost the sane according to this embodiment.

Accordingly, it is possible to shorten the time of the high level period of the CMND signal going low at time

$$t_{21}$$

as shown by a phantom line in Fig. 8A and at the same time, it is possible to shorten the time of the high level period of the WCK signal and to shift it as shown by a phantom line in Fig. 8D going high at time

$$t_{22}$$

and going low at time

$$t_{23}.$$

In this way according to the present invention, it is possible to speed up the operational speed of the wafer scale integrated circuit device.

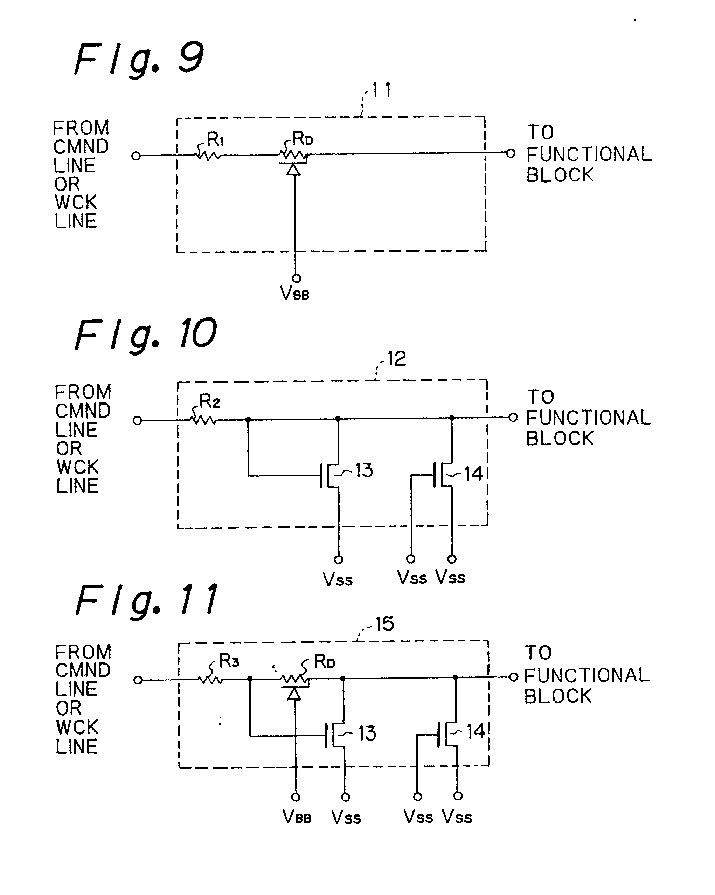

Figures 9 to 11 are other embodiments of the input protection circuit according to the present invention. In the embodiment shown in Fig. 9, the input protection circuit 11 inclues a series connected resistor $R_1$ for dumping and a diffused resistor $R_D$ for bypassing an overshot or an undershot input signal to the substrate voltage supply line $V_{BB}$ .

In the embodiment shown in Fig. 10, the input protection circuit 12 includes a resistor $R_2$, n-channel Metal Oxide Semiconductor Field Effect Transistor (nMOS FET) 13, and nMOS FET 14. The gate and drain of the nMOS FET 13 is connected to the resistor $R_2$ and source of the nMOS FET 13 is connected to the voltage supply line Vss. This nMOS FET 13 is provided for an overshot level and its threshold level is previously set in accordance with a maxmum input voltage level. On the other hand, the nMOS FET 14 is provided for an undershot level with its drain connected to the resistor $R_2$ and gate and source connected to the voltage suppiy line Vss.

The embodiment in Fig. 11 is a combination of the embodiments shown in. Figs 9 and 11, so that the input protection circuit 15 includes a resistor $R_3$, the diffused resistor $R_D$, nMOS FET 13, and nMOS FET 14. The diffused resistor $R_D$ is connected between the gate and drain of the nMOS FET 13.

## Claims

1. A wafer scale integrated circuit device comprising:

a wafer (1);

a plurality of functional blocks ($2_{11}, 2_{21}...2_{nm}$) arranged in rows and columns on the wafer (1);

at least one terminal (41,42) for receiving an external input signal;

at least one signal transmitting line (43,44) for supplying the external input signal to each functional block from the terminal; and,

input circuit protection means,

characterised in that the input circuit protection means comprises:

a plurality of input protection circuits ($5_{11}, 5_{12}...5_{nm}$; $6_{11}, 6_{12},...6_{nm}$) provided individually between each of the said functional blocks and the signal transmitting line (43,44).

2. A wafer scale integrated circuit device as set forth in claim 1, wherein said terminals are a plurality of terminal chips ($2_D$) selectively formed in the circumierence of said wafer, each of said terminal chips having a plurality of relay pads (8).

3. A wafer scale integrated circuit device as set forth in claim 1 or 2, wherein said signal transmitting line is comprised of a plurality of power supply lines constituted by bonding wires (4) which connect each of said functional blocks, a command strobe signal transmitting line (6) for supplying an input command strobe signal to each of said functional blocks, and a wafer clock signal transmitting line (7) for supplying an input wafer clock signal to each of said functional blocks.

4. A wafer scale integrated circuit device as set forth in claim 3, wherein said protection circuits are a plurality of input protection circuits ($5_{11}-5_{nm}$) provided between each of said functional blocks ($2_{R1}, 2_{R2}$) and said command strobe signal transmitting line (6), and a plurality of input protection circuits ($6_{11}-6_{nm}$) provided between said each of said functional blocks ($2_{R1}, 2_{R2}$) and said wafer clock signal transmitting line (7).

5. A wafer scale integrated circuit device as set forth in any preceding claim, wherein said input protection circuit is constituted by a resistor ($R_5, R_6$).

6. A wafer scale integrated circuit device as set forth in any one of claims 1 to 4, wherein said input protection circuit is constituted by a combination of a resistor ($R_1$) and a diffused resistor ($R_D$).

7. A wafer scale integrated circuit device as set forth in any one of claims 1 to 4, wherein said input protection circuit is constituted by a combination of a resistor ($R_2$) and field effect transistors (13,14) made of an n-channel metal oxide semiconductor.

8. A wafer scale integrated circuit device as set forth in any one of claims 1 to 4, wherein said input protection circuit is constituted by a combination of a resistor ($R_3$), a diffused resistor ($R_D$), and field effect transistors (13,14) made of an n-channel metal oxide semiconductor.

9. A wafer scale integrated circuit device as set forth in any preceding claim, wherein said functional blocks ($2_{R1}, 2_{R2}$) are memory functional blocks.

# F i g. 1

# Fig. 2

# $Fig.\ 3$

Fig. 4A

EP 0 413 590 A2

# Fig. 4B

FUNCTIONAL BLOCK

CMND — COMMAND DECODER (21)

Vcc — Vcc SWITCH (22) → DRAM (30)

WCK

DIRECTION SELECTOR (24)

XMIT-N, XMIT-E, XMIT-S, XMIT-W — MPX (26)

RECV-N, RECV-E, RECV-S, RECV-W — MPX (25)

DRAM INTERFACE REFRESH COUNTER (23)

20

2

*Fig. 5A*

H

CMND SIGNAL

L

t₁          t₁₁          TIME

*Fig. 5B*

H

L

t₂          t₁₂          TIME

*Fig. 5C*

H

L

t₃          t₁₃          TIME

*Fig. 5D*

H

WCK SIGNAL

L

t₄          t₁₄          TIME

*Fig. 5E*

H

L

t₅          t₁₅          TIME

*Fig. 5F*

H

L

t₆          t₁₆  TIME

# Fig. 6

EP 0 413 590 A2

# Fig. 7

EP 0 413 590 A2

Fig.8A

Fig.8B

Fig.8C

Fig.8D

Fig.8E

Fig.8F

16

# Fig. 9

FROM
CMND
LINE
OR
WCK
LINE

TO
FUNCTIONAL
BLOCK

$R_1$   $R_D$

11

$V_{BB}$

# Fig. 10

FROM
CMND
LINE
OR
WCK
LINE

TO
FUNCTIONAL
BLOCK

$R_2$

12

13

14

$V_{ss}$   $V_{ss}$  $V_{ss}$

# Fig. 11

FROM
CMND
LINE
OR
WCK
LINE

TO
FUNCTIONAL
BLOCK

$R_3$   $R_D$

15

13

14

$V_{BB}$  $V_{ss}$   $V_{ss}$  $V_{ss}$

17